(19) Europäisches Patentamt
European Patent Office
Office européen des brevets

(11) **EP 2 560 176 A2**

(12) **EUROPEAN PATENT APPLICATION**

(43) Date of publication:
**20.02.2013 Bulletin 2013/08**

(51) Int Cl.:
***H01G 9/20*** (2006.01)

(21) Application number: **12161892.0**

(22) Date of filing: **28.03.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **29.07.2011 KR 20110076140**

(71) Applicant: **Samsung SDI Co., Ltd.**
**Yongin-si, Gyeonggi-do (KR)**

(72) Inventors:
• **Kang, Moon-Sung**
  **Gyeonggi-do (KR)**
• **Lee, Ji-Won**
  **Gyeonggi-do (KR)**
• **Cha, Si-Young**
  **Gyeonggi-do (KR)**

(74) Representative: **Sampson, Eimear et al**
  **Venner Shipley LLP**
  **200 Aldersgate**
  **London EC1A 4HD (GB)**

(54) **Electrolyte for dye-sensitized solar cell and dye-sensitized solar cell using the same**

(57)    An electrolyte for a solar cell comprising a heterogeneous redox couple comprising iodide and a pseudohalogen and a dye-sensitized solar cell including the electrolyte are provided.

EP 2 560 176 A2

**Description**

The present invention relates to an electrolyte for a dye-sensitized solar cell and a dye-sensitized solar cell using the same.

A dye-sensitized solar cell consists of a photocathode on which dye molecules are adsorbed, an electrolyte containing a redox ion couple, and a counter electrode including a platinum catalyst. By irradiating the dye molecules with light, the dye molecules are excited from a ground state to an excited state and electrons thereof are transferred to a semiconductor layer. The excited electrons migrate to the counter electrode through external wiring, and then the redox couple oxidized by the catalyst coated on a surface of the counter electrode is reduced. The reduced redox couple reduces the oxidized dye molecules and thus the dye molecules again have electrons capable of entering the excited state. The conduction band of the semiconductor layer and the potential difference of the redox couple determine the open circuit voltage (Voc).

A redox couple in an electrolyte in a dye-sensitized solar cell is a material included for electron transfer, and can consist of iodine (I)-based, bromine (Br)-based, cobalt (Co)-based, thiocyanate ([SCN])-based, or selenocyanate ([SeCN]-)-based homogeneous elements. Specifically, redox couples consisting of homogeneous elements, such as $I^-/I_3^-$ , $SCN^-/(SCN)_2$, and $SeCN^-/(SeCN)_2$, are generally used.

Iodide-based redox couples $I^-/I_3^-$ are usually used. However, energy conversion efficiency and durability of such redox couples do not reach satisfactory levels.

A first aspect of the invention provides an electrolyte for a dye-sensitized solar cell including a heterogeneous redox couple containing iodide and a pseudohalogen compound.

In an embodiment, the heterogeneous redox couple is $I^-/(SeCN)_2$.

A second aspect of the invention provides a solar cell including the electrolyte for a dye-sensitized solar cell.

A third aspect of the invention relates to the use of an electrolyte comprising a heterogeneous redox couple including iodide and a pseudohalogen in a dye-sensitized solar cell.

The pseudohalogen may be a compound selected from the group consisting of $(CN)_2$, $(SCN)_2$, $(SeCN)_2$,, $SCSN_3$, etc. or an ion selected from the group consisting of $N_3^-$, $CN^-$, $SCN^-$, $SeCN^-$, $OCN-$, etc.

In some embodiments, the heterogeneous redox couple is $I^-/(SeCN)_2$. In some embodiments, the iodide is in the form of one or more components each independently selected from the group consisting of imidazolium iodide, pyridinium iodide, alkali metal iodide, ammonium iodide, and pyrrolidinium iodide. In some embodiments, the pseudohalogen:iodide molar ratio is from about 0.001 to about 10. In some embodiments, the concentration of the iodide is from about 0.5 to about 1.0 M. In some embodiments, the concentration of the $(SeCN)_2$ is from about 0.05 to about 0.3 M. In some embodiments, the electrolyte further comprises an organic solvent. In some embodiments, the organic solvent has a boiling point of about 120°C or more.In some embodiments, the organic solvent has a boiling point of about 150°C or more. In some embodiments, the organic solvent is one or more components each independently selected from the group consisting of γ-butyrolactone (GBL), N-methyl-2-pyrrolidone (NMP), benzonitrile (BN), dimethylsulfoxide (DMSO), dimethyl acetamide (DMAA), N,N-dimethylethanamide (DMEA), 3-methoxypropionitrile (MPN), diglyme, diethylformamide (DEF), and dimethylformamide (DMF).

According to a second aspect of the invention, a dye-sensitized solar cell includes a first electrode; a light absorption layer formed on a side of the first electrode; a second electrode disposed to face the first electrode on which the light absorption layer is formed; and an electrolyte disposed between the first electrode and the second electrode and including a heterogeneous redox couple containing iodide and a pseudohalogen compound. In some embodiments, the pseudohalogen is one or more components each independently selected from the group consisting of $(CN)_2$, $(SCN)_2$, $(SeCN)_2$, $N_3^-$, $SCSN_3$, $CN-$, $SCN-$, $SeCN^-$, and $OCN^-$. In some embodiments, the heterogeneous redox couple is $I^-/(SeCN)_2$. In some embodiments, the iodide comprises one or more components each independently selected from the group consisting of imidazolium iodide, pyridinium iodide, alkali metal iodide, ammonium iodide, and pyrrolidinium iodide. In some embodiments, the pseudohalogen:iodide molar ratio is from about 0.001 to about 10. In some embodiments, the dye-sensitized solar cell further comprises dye molecules.

A more complete appreciation of the present invention and many of the attendant advantages thereof, will be readily apparent as the same becomes better understood by reference to the following detailed description when considered in conjunction with the accompanying drawings, wherein:

FIGURE 1 illustrates a redox potential for redox couples of electrolytes for dye-sensitized solar cells;

FIGURE 2 is a schematic view illustrating an operating principle of a dye-sensitized solar cell;

FIGURE 3 illustrates a schematic structure of a dye-sensitized solar cell according to an aspect of the present invention;

FIGURE 4 is a graph showing characteristics of voltage and current according to Example 1 and Comparative Example 1; and

FIGURE 5 is a graph showing efficiency characteristics according to Example 1 and Comparative Example 1 over time.

An electrolyte for a dye-sensitized solar cell according to the invention includes a heterogeneous redox couple including iodide and a pseudohalogen.

As used herein, the term "pseudohalogen" refers to a compound having a group exhibiting properties similar to those of halogen atoms, or a compound in which two such groups are bound, and corresponds to a pseudohalogen compound or a pseudohalogen ion. For example, the pseudohalogen compound may be $(CN)_2$, $(SCN)_2$, $(SeCN)_2$, or $SCSN_3$, and the pseudohalogen ion may be $N_3^-$, $CN^-$, $SCN^-$, $SeCN^-$, or $OCN^-$.

The term "iodide" refers to iodine, an iodide ion, or an iodide-containing compound.

In some embodiments, the heterogeneous redox couple employs existing $I^-$ as a reducing agent and employs a pseudohalogen in order to form an oxidizing agent, and thus may provide a higher ion diffusion coefficient and higher voltage characteristics than existing iodide-based homogeneous redox couples. In addition, the amount of the pseudohalogen in the electrolyte for a dye-sensitized solar cell is smaller than the amount of a pseudohalogen in a homogeneous pseudohalogen electrolyte using only the pseudohalogen to form a redox couple, and thus the heterogeneous redox couple is excellent environmentally and in terms of stability with respect to the addition of pseudohalogens.

In some embodiments, the pseudohalogen:iodide molar ratio may be from about 0.001 to about 10.

When the pseudohalogen:iodide molar ratio is in the above range, stability of the electrolyte for a dye-sensitized solar cell can be excellent.

In some embodiments, the concentration of iodide in the heterogeneous redox couple may be from about 0.5 to about 1.0 M.

For example, the heterogeneous redox couple in the electrolyte for a dye-sensitized solar cell may be $I^-/(SeCN)_2$, but is not limited thereto. In some embodiments, the concentration of $(SeCN)_2$ in the heterogeneous redox couple may be from about 0.05 to about 0.3 M.

In addition, the heterogeneous redox couple $I^-/(SeCN)_2$ can be excellent environmentally and in terms of stability because the amount of Se in the heterogeneous redox couple is about 1/10th the amount of Se in existing homogeneous redox couples $SeCN^-/(SeCN)_2$.

In some embodiments, the heterogeneous redox couple $I^-/(SeCN)_2$ may employ existing $I^-$ as a reducing agent and employ $(SeCN)_2$ in order to form an oxidizing agent. Through this, performance of the electrolytes using the heterogeneous redox couple can be equivalent to or better than that of existing iodide-based electrolytes and stability of the electrolyte may be improved.

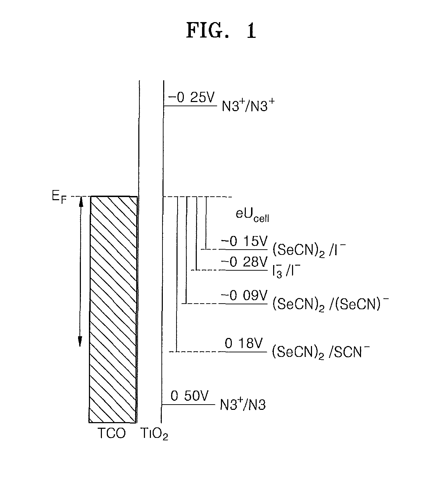

FIGURE 1 shows the redox potential for redox couples of electrolytes for dye-sensitized solar cells. As shown in FIGURE 1, the heterogeneous redox couple of the present invention including iodide and a pseudohalogen compound may have a higher voltage than a homogeneous redox couple $I^-/I_3^-$ because the redox potential of the heterogeneous redox couple has a positive shift. The heterogeneous redox couple may have a more negative energy level than the HOMO (Higher Order Molecular Orbital) position of a typical photosensitive dye, and thus may deliver electrons to dye molecules in a ground state more easily.

An electron delivery reaction mechanism of the heterogeneous redox couple $I^-/(SeCN)_2$ according to an embodiment of the present invention is represented by the following Formula 1.

$$\text{Formula 1} \qquad I(SeCN)_2^- + 2e^- \rightarrow I^- + {}_2(SeCN)^-$$

In some embodiments, the iodide ion ($I^-$) may be provided from an iodide of a nitrogen-containing heterocyclic compound, such as an imidazolium salt, a pyridinium salt, a quaternary ammonium salt, a pyrrolidinium salt, , a pyrazolidium salt, an isothiazolidinium salt, an isooxazolidinium salt, etc. For example, the iodide ion may be provided from imidazolium iodide, pyridinium iodide, an alkali metal iodide, ammonium iodide, pyrrolidinium iodide, etc.

In some embodiments, the electrolyte for a dye-sensitized solar cell may further include an organic solvent. According to an embodiment, the organic solvent may have a boiling point of about 120°C or morewhich includes, for example, propanediol-1,2-carbonate (PDC), ethylene carbonate (EC), diethylene glycol (DEG), propylene carbonate (PC), hexamethylphosphoric triamide (HMPA), ethyl acetate, nitrobenzene, formamide, $\gamma$-butyrolactone (GBL), benzyl alcohol, N-methyl-2-pyrrolidone (NMP), acetophenone, ethylene glycol, trifluorophosphate, benzonitrile, dimethylsulfoxide (DMSO), dimethyl sulfate, aniline, N-methylformamide (NMF), phenol, 1,2-dichlorobenzene, tri-n-butyl phosphate, o-dichlorobenzene, selenium oxychloride, ethylene sulfate, benzenethiol, dimethyl acetamide (DMA), N,N-dimethylethanamide, 3-methoxypropionitrile, diglyme, cyclohexanol, bromobenzene, cyclohexanone, anisole, diethylformamide, dimethylformamide (DMF), 1-hexanethiol, hydrogen peroxide, bromoform, ethylchloroacetate, 1-dodecanethiol, di-n-butyl ether, dibutyl ether, acetic anhydride, m-xylene, p-xylene, chlorobenzene, morpholine, diisopropyl ethylamine, diethyl carbonate (DEC), 1-pentanediol, or n-butyl acetate 1-hexadecanethiol.

According to an embodiment, the organic solvent may have a boiling point of about 150°C or more, which includes, for example, γ-butyrolactone (GBL), N-methyl-2-pyrrolidone (NMP), benzonitrile (BN), dimethylsulfoxide (DMSO), dimethyl acetamide (DMAA), N,N-dimethylethanamide (DMEA), 3-methoxypropionitrile, diglyme, diethylformamide (DEF), or dimethylformamide (DMF).

In some embodiments, iodide may be included in an amount of about 0.3 to about 1.5 M, or for example, in an amount of about 0.5 to about 1.0 M, in the electrolyte for a dye-sensitized solar cell. In the above concentration range, delivery of electrons to a dye in a ground state through a reversible redox reaction can occur more easily.

In some embodiments, $(SeCN)_2$ may be included in an amount of about 0.01 to about 0.5 mol/l, or for example, in an amount of about 0.05 to about 0.3 mol/l, in the electrolyte for a dye-sensitized solar cell. In the above concentration range, selenium is present in a relatively small amount, and thus the electrolyte for a dye-sensitized solar cell is excellent environmentally and in terms of stability, compared to similar pseudohalogen-based homogeneous redox couple electrolytes.

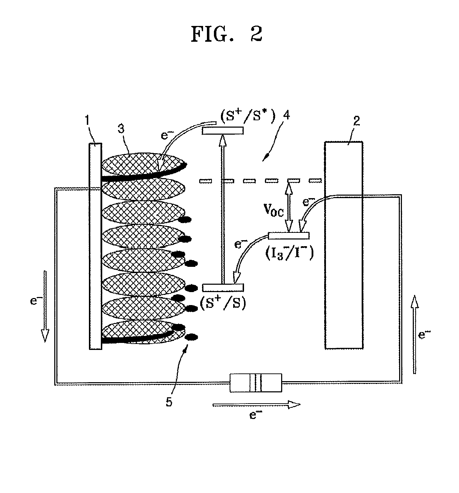

FIGURE 2 shows an operating principle of a general dye-sensitized solar cell. Electron-hole pairs can be created as the dye molecules **5** are excited from a ground state to an excited state and then electrons thereof can be transferred away from the dye molecules **5** if solar light rays are absorbed by dye molecules **5.** The excited electrons can be injected into a conduction band at an interface of particles of a porous membrane **3,** and then the injected electrons can be transferred to a first electrode **1** through an interface with the first electrode **1** and then transferred to a second electrode **2** through an external circuit. The dye molecules **5** oxidized as a result of the electron transfer can be reduced by iodide ions ($I^-$) of redox couples in an electrolyte solution **4,** and the oxidized iodide ions, that is, trivalent iodide ions ($I_3^-$), are involved in a reduction reaction with electrons that have arrived at the interface of the second electrode **2** in order to achieve charge neutrality to operate the cell. The dye-sensitized solar cell can use an electrochemical principle of operating the cell through reactions at an interface, unlike existing **p-n** junction type silicon-based solar cells.

According to another aspect there is provided a dye-sensitized solar cell including a first electrode; a light absorption layer formed on a side of the first electrode; a second electrode disposed to face the first electrode on which the light absorption layer is formed; and the electrolyte according to the invention in its first aspect disposed between the first electrode and the second electrode.

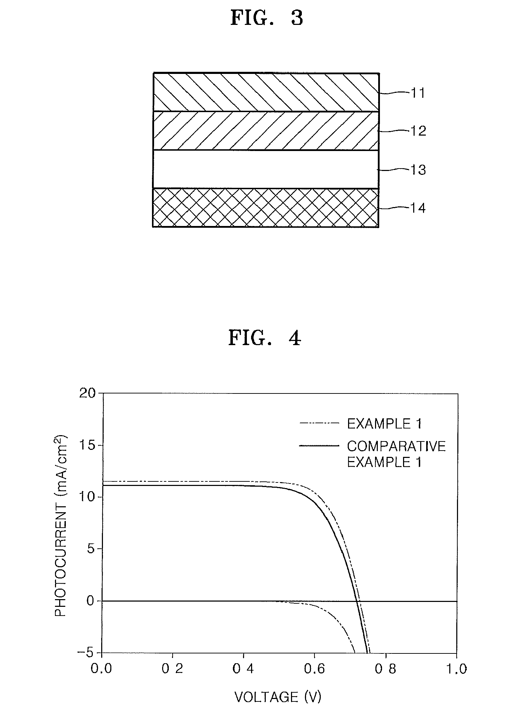

FIGURE 3 schematically illustrates an example of the dye-sensitized solar cell. The solar cell includes a first electrode **11,** a light absorption layer **12,** an electrolyte **13,** and a second electrode **14.** The light absorption layer **12** may include semiconductor particles and dye molecules. The first electrode **11** and the light absorption layer **12** can be collectively called a semiconductor electrode.

The electrode **13** may be as described above. The first electrode **11** may include a transparent substrate and a conductive layer formed on the transparent substrate. The transparent substrate may be formed of any suitable transparent material that transmits external light without particular limitation. For example, the transparent substrate may be formed of glass or plastic. Specific examples of the plastic may include polyethylene terephthalate (PET), polyethylene naphthalate (PEN), polycarbonate (PC), polypropylene (PP), polyimide (PI), triacetyl cellulose (TAC), polyethersulfone, and copolymers thereof.

The transparent substrate may be doped with a doping material selected from the group consisting of titanium (Ti), indium (In), gallium (Ga), and aluminum (Al).

The conductive layer can be disposed on the transparent substrate.

The conductive layer may include a conductive metal oxide selected from the group consisting of indium tin oxide (ITO), fluorine tin oxide (FTO), ZnO-($Ga_{2O3}$ or $Al_2O_3$), a tin-based oxide, antimony tin oxide (ATO), zinc oxide, and combinations thereof. For example, $SnO_2$ may be used for its suitable conductivity, transparency, and heat resistance, indium tin oxide (ITO) may be used relatively inexpensively and alone, and a complex layer of indium tin oxide (ITO) and other heterogeneous metal oxide layers may be used in order to reduce resistance after heat treatment.

The conductive layer may be formed of a single-layer film or a multi-layer film of the conductive metal oxide.

A porous membrane including the semiconductor particulates and the light absorption layer **12** including the photosensitive dye molecules adsorbed on a surface of the porous membrane are formed on the first electrode **11.** The porous membrane can be uniformly nanoporous, and the semiconductor particulates thereof can have a very minute and uniform average particle diameter.

The semiconductor particles may be a compound semiconductor or a compound having a Perovskite structure as well as a single element semiconductor represented by silicon. The semiconductor may be an **n**-type semiconductor that provides an anode current under optical excitation by employing electrons in a conduction band as carriers. The compound semiconductor may be, for example, an oxide of a metal selected from the group consisting of titanium (Ti), zirconium (Zr), strontium (Sr), zinc (Zn), indium (In), ytterbium (Yb), lanthanum (La), vanadium (V), molybdenum (Mo), tungsten (W), tin (Sn), niobium (Nb), magnesium (Mg), aluminium (Al), yttrium (Y), scandium (Sc), samarium (Sm), gallium (Ga), indium (In), and TiSr. The compound semiconductor may be titanium dioxide ($TiO_2$), tin oxide ($SnO_2$), zinc

oxide (ZnO), tungsten oxide ($WO_3$), niobium oxide ($Nb_2O_5$), and strontium titanate ($TiSrO_3$), or a mixture thereof. In some embodiments, the compound semiconductor may be anatase-type $TiO_2$. The semiconductor particles are not limited to the above-mentioned materials, and the above-mentioned materials may be used alone or in a combination thereof. The semiconductor particulates may have a relatively large surface area to allow the dye molecules adsorbed onto a surface of the semiconductor particulates to absorb a relatively great amount of light. The semiconductor particulates may have a particle diameter of about 20 nm or less.

The porous membrane may be manufactured by a typical porous membrane manufacturing method. For example, the porous membrane may be manufactured by a mechanical necking treatment that does not need heat treatment and may control a membrane density of the porous membrane by appropriately controlling treatment conditions, but is not limited thereto.

The dye molecules adsorbed on the surface of the porous membrane can absorb external light to produce excited electrons. Any dye typically used in the field of solar cells may be used without limitation Here, a ruthenium complex will be described. However, the dye is not particularly limited as long as it has a charge separation function and a photosensitizing function. Besides the ruthenium complex, the dye may be, for example, a xanthene dye, such as rhodamine B, rose bengal, eosin, erythrosine, etc., a cyanine dye, such as quinocyanine, cryptocyanine, etc., a basic dye, such as phenosafranine, capri blue, thiosine, methylene blue, etc., a porphyrin-based compound, such as chlorophyll, zinc porphyrin, magnesium porphyrin, etc., any of various azo dyes; a complex compound, such as a phthalocyanine compound, ruthenium trisbipyridyl, etc., an anthraquinone-based dye, and a polycyclic quinine-based dye, and these may be used alone or in a combination thereof. In some embodiments, the ruthenium complex may include, for example, $RuL_2(SCN)_2$, $RuL_2(H_2O)_2$, $RuL_3$, or $RuL_2$ (where **L** is, for example, 2,2'-bipyridyl-4,4'-dicarboxylate or other bidentate molecules).

The light absorption layer 12 may have a thickness of about 15 $\mu$m or less, for example, about 1 to about 15 $\mu$m.

The counter electrode 14 can be disposed to face the first electrode 11 on which the light absorption layer 12 can be formed.

Any material may be used, without limitation, as the second electrode **14** as long as it is a conductive material. An insulating material may be used as the second electrode **14** if a conductive layer is disposed on a side facing the semiconductor electrode. However, the conductive layer should be an electrochemically stable material that may be used as an electrode, and specific examples of the material include, but are not limited to, platinum (Pt), gold (Au), and carbon (C). The side of the electrode facing the semiconductor layer may have a fine structure and an increased surface area to improve a catalyst effect of a redox reaction. For example, when using platinum, the platinum should be in a platinum black state, and when using carbon, the carbon should be in a porous state. The platinum black state may be achieved by performing an anodizing method, a platinum chloride acid treatment, or the like on platinum. The porous state may be achieved by performing a method of sintering carbon microparticles, a method of sintering an organic polymer, or the like on carbon.

Methods of manufacturing a solar cell with the above-described structure are well known in the art and are understood by those skilled in the art.

The present invention is described in more detail with reference to examples and comparative examples below.

Preparation Example 1

Preparation of Electrolyte

For the synthesis of an $(SeCN)_2$ powder, 6 g of KSeCN and 7.1 g of $AgNO_3$ were first dissolved at a molar ratio of 1:1 in 20 g of ultrapure water. A precipitate was produced according to the following reaction and collected by filtration to obtain AgSeCN.

$$KSeCN + AgNO_3 \rightarrow AgSeCN$$

Subsequently, 4.3 g of AgSeCN was dissolved in 20 g of methylene chloride (DCM), 2.6 g of iodine ($I_2$) was added to the solution, and $(SeCN)_2$ was produced according to the following reaction.

$$2AgSeCN + I_2 \rightarrow (SeCN)_2 + {}_2AgI$$

AgI was precipitated according to the reaction, $(SeCN)_2$ was obtained in a solution state, and the solvent was evaporated to obtain an $(SeCN)_2$ powder.

All reagents used in the process were purchased from Aldrich (St. Louis, MO) and used without further purification.

As a solvent for preparing an electrolyte, 3-methoxypropionitrile (MPN) was purchased from Aldrich and used without further purification. 1.0 M of 1-butyl-3-methyl imidazolium iodide (BMImI) and 0.1 M of (SeCN)$_2$ were dissolved in 10 g of 3-methoxypropionitrile to prepare an electrolyte.

Comparative Preparation Example 1

Preparation of Electrolyte

In order to prepare an iodide electrolyte, 3-methoxypropionitrile (MPN) was used as a solvent and 2.7 g and 0.26 g of 1-butyl-3-methyl imidazolium iodide (BMImI) were dissolved in 10 g of 3-methoxypropionitrile, respectively, to prepare 1.0 M 1-butyl-3-methyl imidazolium iodide (BMImI) and 0.1 M I$_2$ electrolytes. All reagents used in the process were purchased from Aldrich and used without further purification.

Example 1

Manufacture of Dye-Sensitized Solar Cell

A TiO$_2$ paste (PST-18NR, JGC C&C, Japan) was applied on a surface of a fluorine-containing tin oxide (FTO) substrate (thickness: about 2.3 mm) at a thickness of about 12 $\mu$m by screen printing and sintered at a heating rate of about 10°C/min at about 500°C for 30 min, and subsequently a scattering particle paste (400c, JGC C&C, Japan) was printed/sintered in the same manner and a photocathode with a thickness of about 4 $\mu$m was manufactured after the sintering.

The photocathode thus manufactured was immersed in a dye solution (0.2 mM N$_{719}$/EtOH) and left therein for 24 hrs. A counter electrode was prepared by performing Pt sputtering on the FTO substrate for 20 min.

A hot melt film (Suryln, DuPont Wilmington, Delaware, 60 $\mu$m) was inserted between the photocathode and the counter electrode where holes are formed and then subjected to heat sealing (130°C/15 sec) by using a hot press. The electrolyte prepared in Preparation Example 1 was injected into holes formed in the counter electrode.

Comparative Example 1

Manufacture of Dye-Sensitized Solar Cell

A dye-sensitized solar cell was manufactured in the same manner as in Example 1, except that the electrolyte manufactured in Comparative Preparation Example 1 was used instead of the electrolyte prepared in Preparation Example 1.

Evaluation Example 1

A current-voltage curve of the manufactured cell was evaluated under standard measurement conditions (AM1.5G,100 mW cm$^{-2}$).

In addition, conditions in which open circuit voltages, photocurrent densities, and fill factors of the dye-sensitized solar cells manufactured according to Example 1 and Comparative Example 1 were measured were as follows.

(1) Open circuit voltage (Voc) and photocurrent density

The open circuit voltages and the photocurrent densities were measured using a Keithley SMU$_{2400}$ SourceMeter (Cleveland, OH).

(2) Energy conversion efficiency (R) and fill factor (FF)

Energy conversion efficiencies were measured by using a solar simulator (consisting of an Xe lamp [300W, Oriel Instruments Irvine, CA], an AM1.5 filter, and a Keithley SMU$_{2400}$) with 1.5AM 100 mW/cm$^2$, and the fill factors were calculated by using the conversion efficiencies previously obtained and the following Calculation Formula.

Calculation Formula

$$\text{Fill Factor (\%)} = \frac{(J \times V)_{max}}{J_{sc} \times V_{oc}} \times 100$$

where, **J** is a Y-axis value of a conversion efficiency curve, **V** is a X-axis value of the conversion efficiency curve, and **Jsc** and **Voc** are intercepts of each axis.

The electrolytes according to Preparation Example 1 and Comparative Preparation Example 1 were used to manufacture the dye-sensitized solar cells in Example 1 and Comparative Example 1.Initial efficiencies were measured, and results are shown in the following Table 1.

Table 1

| Electrolyte | Initial efficiency | | | |
|---|---|---|---|---|
| | $J_{sc}$ (mA cm$^{-2}$) | Voc (V) | FF (%) | R (%) |
| Comparative Example 1 (BMImI/$I_2$) | 11.405 | 0.755 | 74.7 | 6.44 |
| Example 1 (BMImI/Se(CN)$_2$) | 11.380 | 0.767 | 75.1 | 6.56 |

In addition, characteristics of voltage and current of the dye-sensitized solar cells manufactured in Example 1 and Comparative Example 1 are shown in FIGURE 4.

As shown in FIGURE 4, it was determined that voltage and current were increased when the $I^-/(SeCN)_2$ heterogeneous redox couple was used. The increase in voltage and the increase in current were due to a positive shift and enhanced ion diffusion degree, respectively.

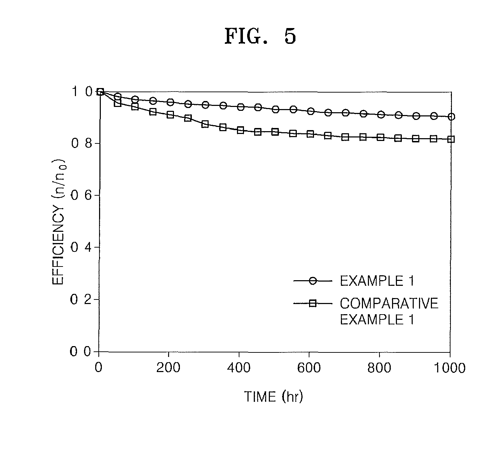

In addition, efficiency characteristics over time as a result of a high-temperature (60°C) service-time evaluation measured under a standard light source condition of about 100 mW/cm$^2$ on the dye-sensitized solar cells of Example 1 and Comparative Example 1, which were manufactured by using the electrolytes of Preparation Example 1 and Comparative Preparation Example 1, are shown in FIGURE 5.

FIGURE 5 provides confirmation that the electrolyte of Preparation Example 1 had better efficiency stability than the electrolyte of Comparative Preparation Example 1.

The efficiency values in FIGURE 5 are given as a ratio of efficiency ($\eta$) over time relative to initial efficiency ($\eta_o$) at a time o.

A solar cell including an electrolyte for a solar cell according to an aspect of the present invention allows voltage and current to increase and may have excellent electro-optical conversion efficiency and excellent efficiency stability.

While the present invention has been described in connection with certain exemplary embodiments thereof, it is to be understood that the invention is not limited to the disclosed embodiments, but, on the contrary, is intended to cover various modifications and equivalent arrangements included within the scope of the appended claims.

**Claims**

1. An electrolyte for a solar cell, comprising:

    a heterogeneous redox couple comprising iodide and a pseudohalogen.

2. The electrolyte of claim 1, wherein the pseudohalogen is selected from the group consisting of $(CN)_2$, $(SCN)_2$, $(SeCN)_2$, $N_3^-$, $SCSN_3$, CN-, SCN-, SeCN-, and OCN-, and combinations thereof

3. The electrolyte of claim 1 or claim 2, wherein the heterogeneous redox couple is $I^-/(SeCN)_2$.

4. The electrolyte ofany preceding claim, wherein the iodide is selected from the group consisting of imidazolium iodide, pyridinium iodide, alkali metal iodide, ammonium iodide, pyrrolidinium iodide, and combinations thereof.

5. The electrolyte of any preceding claim, wherein the pseudohalogen:iodide molar ratio is from 0.001 to 10.

6. The electrolyte of any preceding claim, wherein the concentration of the iodide is from 0.5 to 1.0 M.

7.  The electrolyte of anyof claims 3 to 6, wherein the concentration of $(SeCN)_2$ is from 0.05 to 0.3 M.

8.  The electrolyte of any preceding claim, further comprising an organic solvent.

9.  The electrolyte of claim 8, wherein the organic solvent has a boiling point of 120°C or more.

10.  The electrolyte of claim 9, wherein the organic solvent has a boiling point of 150°C or more.

11.  The electrolyte of any of claims 8 to 10, wherein the organic solvent is one or more components each independently selected from the group consisting of γ-butyrolactone (GBL), N-methyl-2-pyrrolidone (NMP), benzonitrile (BN), dimethylsulfoxide (DMSO), dimethyl acetamide (DMAA), N,N-dimethylethanamide (DMEA), 3-methoxypropionitrile (MPN), diglyme, diethylformamide (DEF), and dimethylformamide (DMF).

12.  A dye-sensitized solar cell, comprising:

    a first electrode;
    a light absorption layer formed on a side of the first electrode;
    a second electrode disposed to face the first electrode on which the light absorption layer is formed; and
    an electrolyte as claimed in any of claims 1 to 11 disposed between the first electrode and the second electrode.

13.  The dye-sensitized solar cell of claim 12, further comprising dye molecules.

14.  Use of an electrolyte comprising a heterogeneous redox couple including iodide and a pseudohalogen, in a dye-sensitized solar cell.

# FIG. 1

FIG. 2

# FIG. 3

# FIG. 4

FIG. 5